# EUROPÄISCHE PATENTSCHRIFT

(11) **EP 2 997 659 B1**
(45) Veröffentlichungstag und Bekanntmachung des Hinweises auf die Patenterteilung: **29.07.2020**
(21) Anmeldenummer: 14725362.9
(22) Anmeldetag: 10.05.2014
(51) Int. Cl.: H03K 17/96, H03K 17/98, H03K 17/975

(54) **BETÄTIGUNGSELEMENT**
ACTUATING ELEMENT
ÉLÉMENT D'ACTIONNEMENT

(30) Priorität: 17.05.2013 DE 102013008567
(43) Veröffentlichungstag der Anmeldung: 23.03.2016
(73) Patentinhaber: Diehl AKO Stiftung & Co. KG, 88239 Wangen (DE)
(72) Erfinder: LYSZUS, Joachim, 88255 Baindt (DE); FUHGE, Bruno, 88147 Achberg (DE)
(74) Vertreter: Diehl Patentabteilung
(86) Internationale Anmeldenummer: PCT/EP2014/001258
(87) Internationale Veröffentlichungsnummer: WO 2014/183856

(56) Entgegenhaltungen:
- EP-A1- 2 228 905
- EP-A2- 0 920 042
- WO-A2-2004/040606
- WO-A2-2011/130755
- US-A1- 2009 009 491

## Beschreibung

Die vorliegende Erfindung betrifft ein Betätigungselement, insbesondere ein solches Dreh-Betätigungselement, insbesondere ein solches Betätigungselement mit einer kapazitiven Sensorik, und insbesondere ein solches Betätigungselement für elektronische Haushaltsgeräte.

In vielen elektronischen Haushaltsgeräten, wie Herden, Kochfeldern, Mikrowellenöfen, Spülmaschinen, Waschmaschinen, Wäschetrocknern und dergleichen werden häufig Betätigungselemente in der Form von Drehknöpfen bzw. Drehknebeln, Schiebereglern und dergleichen eingesetzt, mit denen ein Benutzer bestimmte Geräteeinstellungen vornehmen kann. Herkömmliche Drehknebel mit einem mechanischen Funktionsprinzip weisen ein Bedienelement auf, welches auf einer Schalterwelle drehbar gelagert ist, wobei diese Schalterwelle durch eine Durchgangsbohrung in der Bedienblende hindurch geführt ist.
Neben Betätigungselementen mit einem mechanischen Funktionsprinzip sind in diesem Zusammenhang auch Betätigungselemente bekannt, welche nach einem kapazitiven, induktiven, optischen, thermischen und/oder piezoelektrischen Funktionsprinzip arbeiten. Im Fall eines kapazitiven Betätigungselements bildet eine Messelektrode aus einem elektrisch leitfähigen Material zusammen mit zum Beispiel einem Finger eines Benutzers über eine als Dielektrikum wirkende Abdeckung aus einem elektrisch isolierenden Material eine Kapazität, die entsprechend dem Betätigen des Betätigungselements variabel ist. Eine Veränderung des Kapazitätswertes an der Messelektrode wirkt sich entsprechend auf ein Ausgangssignal der zugehörigen Sensorschaltung aus, welches von einer Auswerte/Steuerelektronik verarbeitet und ausgewertet werden kann, um ggf. eine Betätigung des kapazitiven Betätigungselements zu erfassen.

Die DE 10 2004 013 947 B3 offenbart eine Bedienvorrichtung für ein Glaskeramikkochfeld in der Form eines Drehknebels, bei welcher an der Unterseite des Drehknebels ein ringförmiger Messstreifen mit sich verändernden physikalischen Eigenschaften vorgesehen ist und das Glaskeramikkochfeld wenigstens einen vorzugsweise optischen oder kapazitiven Sensor zum Erfassen der ihm auf Seiten des Drehknebels gegenüber liegenden physikalischen Eigenschaften aufweist.

Aus der WO 2004/040606 A2 ist eine Bedienvorrichtung bekannt, die sich eines Drehknebels mit einer ortsfesten Sensorelektrode bedient, die über kreisförmig angeordnete Sensoren bei Betätigung des Drehknebels geführt wird und dabei ein kapazitives Schaltsignal auslöst. Eine andere Drehbetätigungserfassungsvorrichtung mit einem drehend zu betätigenden Knopf, der mit umlaufenden kapazitiven Sensorelektroden wechselwirkt, ist aus der EP 2 228 905 B1 bekannt.

Die WO 2010/115014 A1 offenbart einen "virtuellen" Drehknopf, welcher drehfest auf der Benutzerseite einer Bedienblende angeordnet ist und eine Fingerbewegung eines Benutzers entlang einer Kreisbahn führt. Diese Fingerbewegung eines Benutzers wird durch kapazitive Sensorelektroden erfasst, welche kreisförmig auf einer Platine auf der dem Benutzer abgewandten Seite der Bedienblende angeordnet sind.

Aus der EP 1 704 642 B1 ist eine Bedieneinrichtung mit einem kapazitiven Sensorelement für ein Elektrohaushaltsgerät bekannt, bei welcher die Bedienung durch Drücken auf ein formveränderliches oder elastisches, zumindest auf seiner Außenseite elektrisch leitfähiges Bedienfeld mit einem kapazitiven Sensorelement darunter und Erfassen einer durch eine Abstandsänderung verursachten Kapazitätsänderung zwischen Sensorelement und Bedienfeld erfolgt. Eine weitere Bedieneinrichtung mit einem kapazitiven Sensorelement, bei der die Bedienung durch Drücken auf ein elastisches Bedienfeld und einer damit verursachten Kapazitätsänderung erfolgt, ist aus der WO 2011/130755 A1 bekannt.

Die US 2009/0009491 A1 offenbart ein Dreh-Betätigungselement, welches eine Basis mit einem zylindrischen Detektionsabschnitt, eine ringförmige Sensoranordnung entlang des Detektionsabschnitts sowie ein elektrisch nicht-leitfähiges Bedienelement, das in radialer Richtung von der Sensoranordnung beabstandet ist, aufweist. Die Sensoranordnung kann eine sich verändernde Position der Finger eines Benutzers beim drehen des Bedienelements um die Basis erfassen.

Aus der EP 0 920 042 A2 ist ein auf eine Anzeigevorrichtung aufsetzbares Gerätepanel mit einem Drehknopf bekannt. Der Drehknopf weist einen um eine Drehachse drehbaren Anzeiger auf, der über kreisförmig um die Drehachse herum angeordnete Elektroden führbar ist und in Wechselwirkung mit diesen ein kapazitives Schaltsignal erzeugt.

Es ist die Aufgabe der vorliegenden Erfindung, ein verbessertes Betätigungselement mit einem kapazitiven Funktionsprinzip zu schaffen.

Diese Aufgabe wird gelöst durch ein kapazitives Betätigungselement mit den Merkmalen des Anspruchs 1. Besonders bevorzugte Ausgestaltungen und Weiterbildungen der Erfindung sind Gegenstand der abhängigen Ansprüche.

Das Betätigungselement der Erfindung weist einen elektrisch nicht-leitfähigen Träger, welcher wenigstens einen Detektionsabschnitt definiert; mehrere elektrisch leitfähige Messelektroden, welche zueinander beabstandet entlang des Detektionsabschnitts des Trägers angeordnet sind; und ein Bedienelement, welches in einem ersten vordefinierten Abstand zu den Messelektroden (bzw. einer Anordnung der Messelektroden) angeordnet und relativ zu diesen bewegbar ist, auf. Außerdem weist das Bedienelement wenigstens einen Sensorabschnitt auf, welcher zumindest teilweise elektrisch leitfähig ausgestaltet ist und in einem zweiten vordefinierten Abstand, welcher von dem ersten vordefinierten Abstand verschieden ist, zu den Messelektroden (bzw. der Anordnung der Messelektroden) angeordnet ist, wobei das Bedienelement aus einem elektrisch leitfähigen Material gebildet ist, wobei der Detektionsabschnitt des Trägers im Wesentlichen als eine Mantelfläche eines Zylinders ausgestaltet ist und das Bedienelement im Wesentlichen ringförmig ausgestaltet und im Wesentlichen koaxial zum Detektionsabschnitt des Trägers angeordnet ist.

Das erfindungsgemäße Betätigungselement arbeitet nach dem kapazitiven Funktionsprinzip, wobei die Messelektroden einerseits und der Sensorabschnitt des Bedienelements andererseits mit einem Dielektrikum (gebildet durch die Beabstandung) dazwischen die Elektroden einer Kapazität bilden. Bei einer Bewegung des Bedienelements relativ zur Anordnung der Messelektroden wird auch der Sensorabschnitt relativ zu dieser bewegt. Anhand einer zeitlichen Veränderung der Kapazitätswerte, verursacht durch eine Abstandsänderung zwischen den Elektroden beim Sensorabschnitt, mehrerer oder vorzugsweise aller Messelektroden lassen sich eine Bewegungsrichtung und/oder eine Wegstrecke des Bedienelements ermitteln.

Aufgrund des kapazitiven Funktionsprinzips arbeitet das erfindungsgemäße Betätigungselement verschleißarm, da sich die relativ zueinander bewegenden Sensorkomponenten nicht kontaktieren. Außerdem ist bei der erfindungsgemäßen Ausgestaltung des Betätigungselements das Bedienelement im Wesentlichen aus einem elektrisch leitfähigen Material, vorzugsweise aus einem Metall (bevorzugt Edelstahl oder dergleichen) gebildet. Es ist möglich, das bewegbare Bedienelement elektrisch leitfähig auszubilden oder zumindest an seiner dem Benutzer zugewandten Außenseite elektrisch leitfähig (zum Beispiel metallisch) zu gestalten. Auf diese Weise lassen sich mehr Designfreiheiten und/oder eine bessere Haptik des Bedienelements für den Benutzer erzielen.

Unter einem Träger ist in diesem Zusammenhang jede Art einer strukturellen Einrichtung zu verstehen, welche geeignet ist, die Messelektroden an vorbestimmten Positionen zu halten. Der Träger ist vorzugsweise in Form eines Gehäuses, eines Rahmens oder eines im Wesentlichen massiven Körpers ausgebildet. Der Träger ist aus einem elektrisch nicht-leitfähigen Material, bevorzugt einem Kunststoffmaterial gefertigt. Der Träger ist vorzugsweise als ein ein- oder mehrteiliges Spritzgussteil gefertigt. Der Träger definiert einen oder mehrere Detektionsabschnitte zum Erfassen einer Bewegung des Bedienelements relativ zum Träger. Der Träger ist vorzugsweise auch zum Führen des Bedienelements entlang einer vorbestimmten Bewegungsbahn relativ zum Träger ausgestaltet.

Das Betätigungselement weist mehrere elektrisch leitfähige Messelektroden auf. Vorzugsweise sind zwei, drei, vier, sechs, acht, zwölf oder sechzehn Messelektroden vorgesehen, ohne dass die Erfindung auf diese konkreten Anzahlen beschränkt sein soll. Je mehr Messelektroden vorgesehen sind, umso höher ist die erzielbare Genauigkeit bei der Erfassung einer Bewegung des Bedienelements relativ zur Anordnung der Messelektroden. Die mehreren Messelektroden sind zueinander beabstandet, sodass sie elektrisch voneinander isoliert sind. Dabei sind zwischen den einzelnen Messelektroden vorzugsweise jeweils ein Luftspalt und/oder ein Trennwandabschnitt des Trägers angeordnet. Die mehreren Messelektroden sind vorzugsweise im Wesentlichen gleich zueinander ausgebildet und im Wesentlichen gleichmäßig zueinander beabstandet, es können aber auch unterschiedliche Arten, Formen, Größen und/oder Abstände von Messelektroden in einem Betätigungselement eingesetzt werden.

Die mehreren Messelektroden sind dabei entlang des Detektionsabschnitts des Trägers angeordnet. Unter der Anordnung entlang des Detektionsabschnitts ist in diesem Zusammenhang vorzugsweise eine Anordnung zu verstehen, bei welcher die (z.B. geometrischen) Schwerpunkte der Messelektroden auf einer Linie liegen, welche im Wesentlichen parallel zur Ebene bzw. Fläche des Detektionsabschnitts verläuft. Dies bedeutet, dass die Messelektroden selbst nicht notwendigerweise vollständig parallel zum Detektionsabschnitt verlaufen müssen. Außerdem sind die mehreren Messelektroden vorzugsweise entlang des gesamten Detektionsabschnitts angeordnet, sie können aber wahlweise auch nur entlang eines Teilabschnitts davon vorgesehen sein. Die Messelektroden sind vorzugsweise in einer Reihe oder in zwei oder mehr zueinander parallelen Reihen entlang des Detektionsabschnitts angeordnet.

Der zweite vordefinierte Abstand zwischen dem Sensorabschnitt des Bedienelements und den Messelektroden bzw. der Anordnung der Messelektroden ist von dem ersten vordefinierten Abstand zwischen dem Bedienelement und den Messelektroden bzw. der Anordnung der Messelektroden verschieden, d.h. größer oder kleiner als dieser ausgebildet. Je größer der Unterschied zwischen dem ersten und dem zweiten vordefinierten Abstand ist, umso größer ist die erzielbare Mess- bzw. Auswertegenauigkeit des Betätigungselements. Der zweite vordefinierte Abstand ist vorzugsweise über den gesamten Sensorabschnitt hinweg im Wesentlichen gleich. In anderen erfindungsgemäßen Ausgestaltungen verändert sich der zweite vordefinierte Abstand ein- oder mehrmals, stufenweise oder kontinuierlich über den Sensorabschnitt hinweg.

Das Bedienelement weist wenigstens einen Sensorabschnitt auf, d.h. vorzugsweise einen, zwei, drei oder vier Sensorabschnitte. Im Fall von mehreren, d.h. zwei oder mehr Sensorabschnitten können die zweiten vordefinierten Abstände zu den Messelektroden bzw. der Anordnung der Messelektroden für alle Sensorabschnitte im Wesentlichen gleich zueinander sein oder sich zwischen den Sensorabschnitten unterscheiden.

Das Bedienelement weist wenigstens einen Sensorabschnitt auf. Vorzugsweise ist der Sensorabschnitt integral mit dem Bedienelement ausgebildet (bevorzugt in Form einer Materialverstärkung, Prägung oder dergleichen) oder fest mit diesem verbunden (bevorzugt verklebt, verlötet, verschweißt).

Form und Größe des wenigstens einen Sensorabschnitts sind vorzugsweise im Wesentlichen gleich der Form und/oder der Größe der Messelektroden, wenn diese zwischen den mehreren Messelektroden bevorzugt jeweils im Wesentlichen gleich zueinander sind. Im Fall von mehreren, d.h. zwei oder mehr Sensorabschnitten können diese im Wesentlichen gleiche oder unterschiedliche Formen und/oder Größen haben.

Das Betätigungselement hat die Form eines Drehknopfes.

Der im Wesentlichen zylindrische Detektionsabschnitt hat in diesem Zusammenhang eine im Wesentlichen zylindrische Form mit einer Grundfläche und einer umlaufenden Mantelfläche. Dabei ist die Grundfläche grundsätzlich beliebig geformt, vorzugsweise im Wesentlichen rotationssymmetrisch oder kreisförmig oder (bevorzugt regelmäßig) polygonal. Die Mantelfläche erstreckt sich über eine Höhe, welche wahlweise gleich groß, größer oder kleiner sein kann als die größte Ausdehnung (z.B. Diagonale) der Grundfläche. Die Mantelfläche verläuft ausgehend von der Grundfläche bevorzugt im Wesentlichen geradlinig oder ein- oder mehrfach, konvex oder konkav gekrümmt. Außerdem verläuft die Mantelfläche ausgehend von der Grundfläche bevorzugt im Wesentlichen senkrecht, sich konisch verjüngend oder sich konisch erweiternd. Ferner sind auch Kombinationen der hier genannten Gestaltungsformen der zylindrischen Form des Detektionsabschnitts denkbar. Neben dem Detektionsabschnitt ist vorzugsweise auch der Träger insgesamt im Wesentlichen zylindrisch ausgestaltet.

Die Ringform (oder auch Hülsen-, Buchsen- oder Rohrform) des Bedienelements entspricht im Wesentlichen der Ausgestaltung des zylindrischen Detektionsabschnitts. Die Grundform des Ringes ist grundsätzlich beliebig, bevorzugt ist sie kreisförmig oder (bevorzugt regelmäßig) polygonal.

Bei der Ausgestaltung des Betätigungselements als Drehknopf ist das Bedienelement vorzugsweise endlos bzw. unbegrenzt um den Detektionsabschnitt des Trägers drehbar. In anderen Ausgestaltungen ist bevorzugt eine Begrenzung des Drehwinkels vorgesehen.

In einer bevorzugten Ausgestaltung der Erfindung sind zwischen den Messelektroden bzw. der Anordnung der Messelektroden und dem Bedienelement wenigstens ein elektrisch nicht-leitfähiges Isolationselement und/oder wenigstens ein Luftspalt vorgesehen. Isolationselement und/oder Luftspalt bilden ein Dielektrikum der Kapazität der Sensoranordnung. Das Isolationselement ist aus einem elektrisch nicht-leitfähigen Material, vorzugsweise einem Kunststoffmaterial gefertigt. Eine Schichtdicke des wenigstens einen Isolationselements ist vorzugsweise (zumindest etwas) kleiner gewählt als der kleinere Abstand des ersten und des zweiten vordefinierten Abstandes, sodass das Bedienelement ungehindert relativ zu den Messelektroden bewegt werden kann. Das wenigstens eine Isolationselement ist vorzugsweise fest mit dem Träger verbunden (bevorzugt durch Verkleben, Verrasten, Verpressen, etc.). Im Fall eines im Wesentlichen zylindrischen Detektionsabschnitts ist das wenigstens eine Isolationselement - ähnlich dem Bedienelement - im Wesentlichen ringförmig ausgestaltet.

In einer bevorzugten Ausgestaltung der Erfindung ist das Bedienelement zumindest teilweise elastisch verformbar ausgestaltet. Vorzugsweise ist das Bedienelement bis zu einem dritten vordefinierten Abstand zu den Messelektroden bzw. der Anordnung der Messelektroden verformbar ausgestaltet, welcher von dem ersten vordefinierten Abstand und von dem zweiten vordefinierten Abstand verschieden ist.

Bei dieser Ausgestaltung des Betätigungselements ist neben einer Betätigung als Drehknopf auch eine Betätigung als Drucktaste möglich, sodass die Bedien- bzw. Eingabemöglichkeiten erweitert werden können. Insbesondere ist es vorzugsweise möglich, das Bedienelement durch Druck (z.B. durch einen Finger eines Benutzers) lokal zu verformen und so den Abstand zwischen dem Bedienelement und den Messelektroden an dieser Stelle zu reduzieren. Außerdem kann eine zugehörige Bedienblende einfacher konzipiert werden, da weniger Betätigungselemente integriert werden müssen.

Der dritte vordefinierte Abstand ist vorzugsweise kleiner als der erste vordefinierte Abstand und größer als der zweite vordefinierte Abstand.

Vorzugsweise ist das Bedienelement nur in Bereichen verformbar, die von denen mit einem Sensorabschnitt verschieden ist, d.h. in denen kein Sensorabschnitt vorgesehen ist. Bevorzugt sind diese verformbaren Bereiche des Bedienelements für den Benutzer gekennzeichnet (z.B. optisch und/oder haptisch).

Vorzugsweise sind bei dieser Ausgestaltung des Betätigungselements zwischen den Messelektroden bzw. der Anordnung der Messelektroden und dem Bedienelement wenigstens ein komprimierbares, elektrisch nicht-leitfähiges Isolationselement und/oder ein Luftspalt vorgesehen. Isolationselement und/oder Luftspalt bilden ein Dielektrikum der Kapazität der Sensoranordnung. Das Isolationselement ist aus einem elektrisch nicht-leitfähigen Material, vorzugsweise einem Kunststoffmaterial oder einem Schaumstoffmaterial gefertigt. Eine Schichtdicke des wenigstens einen Isolationselements ist im nicht komprimierten Zustand vorzugsweise (zumindest etwas) kleiner gewählt als der kleinere Abstand des ersten und des zweiten vordefinierten Abstandes, sodass das Bedienelement ungehindert relativ zu den Messelektroden bewegt werden kann.

In einer bevorzugten Ausgestaltung der Erfindung sind die Messelektroden mit einer Steuervorrichtung verbunden, welche in/an dem Betätigungselement, besonders bevorzugt innerhalb des Trägers, angeordnet ist. In anderen Ausgestaltungen der Erfindung kann die Steuervorrichtung auch separat von dem Betätigungselement vorgesehen sein. Die Steuervorrichtung ist vorzugsweise ausgestaltet, um die Messsignale an den mehreren Messelektroden auszuwerten. Die Steuervorrichtung ist vorzugsweise ausgestaltet, um die zu den einzelnen Messelektroden gehörenden Kapazitätswerte und ihre Veränderungen im Wesentlichen parallel zueinander oder sequentiell zu erfassen. Vorzugsweise ist die Steuervorrichtung ausgestaltet, um anhand der zu den Sensorelementen gehörenden Kapazitätswerte bzw. Kapazitätswertänderungen ein Bewegungsmaß und/oder eine Bewegungsrichtung, im Fall eines Drehknopfes einen Drehwinkel und/oder eine Drehrichtung einer Relativbewegung des Bedienelements zu erfassen.

In einer weiteren bevorzugten Ausgestaltung der Erfindung weist das Betätigungselement eine dem Benutzer zugewandte (stirnseitige) Abdeckung, welche zumindest teilweise lichtdurchlässig ausgebildet ist, und wenigstens ein Anzeigeelement auf.

Bei dieser Ausgestaltung verfügt das Betätigungselement der Erfindung zusätzlich über wenigstens ein Anzeigeelement. Dies erleichtert die Bedienung des Betätigungselements für den Benutzer, da dem Benutzer über das wenigstens eine Anzeigeelement Informationen (z.B. Einstellmöglichkeiten, aktuelle Einstellwerte, Betriebszustand, etc.) mitgeteilt werden können. Außerdem kann eine Bedieneinheit mit dieser Ausgestaltung des Betätigungselements kompakter und platzsparender ausgebildet werden, da auf zusätzliche Anzeigeelemente neben dem Betätigungselement verzichtet werden kann. Außerdem kann eine Bedienblende ggf. einfacher konzipiert werden, da weniger Elemente integriert werden müssen.

Unter einem Anzeigeelement soll in diesem Zusammenhang jede Art von Einrichtung verstanden werden, die geeignet ist, dem Benutzer Information optisch darzustellen. Zu den geeigneten Anzeigeelementen zählen insbesondere einfache Leuchtelemente (z.B. Leuchtioden oder Leuchtdiodengruppen), mit Leuchtelementen gekoppelte Lichtleiter, Displays (z.B. LED, LCD, etc.) und dergleichen. Das wenigstens eine Anzeigeelement weist vorzugsweise ein, zwei, drei oder vier Anzeigeelemente oder eine Einheit aus zwei oder mehr Anzeigeelementen auf.

Die Abdeckung ist vorzugsweise aus einem elektrisch nicht-leitfähigen Material, bevorzugt einem Kunststoffmaterial gefertigt. Die Abdeckung ist vorzugsweise als ein ein- oder mehrteiliges Spritzgussteil gefertigt. Die Abdeckung ist vorzugsweise lösbar oder dauerhaft mit dem Träger des Befestigungselements verbunden. Die Verbindung zwischen Abdeckung und Träger erfolgt vorzugsweise mittels Verrasten, Verclipsen, Verkleben, Presspassung, Verschrauben oder dergleichen.

Das oben beschriebene Betätigungselement der Erfindung ist vorzugsweise in einem elektronischen Haushaltsgerät, wie beispielsweise einem Herd, einem Kochfeld, einem Mikrowellenofen, einer Spülmaschine, einer Waschmaschine, einem Wäschetrockner und dergleichen einsetzbar. Das Betätigungselement der Erfindung wird dabei vorzugsweise auf einer Bedienblende des Haushaltsgerätes montiert oder durch eine solche hindurch gesteckt.

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnung besser verständlich. Darin zeigen, zum Teil schematisch:
- Fig. 1: eine Seitenansicht eines Betätigungselements gemäß einem Ausführungsbeispiel der vorliegenden Erfindung, teilweise im Schnitt;
- Fig. 2: eine Querschnittansicht des in Fig. 1 dargestellten Betätigungselements gemäß Schnittlinie A-A in Fig. 1 in einem ersten Betätigungszustand; und
- Fig. 3: eine Querschnittansicht des in Fig. 1 dargestellten Betätigungselements gemäß Schnittlinie A-A in Fig. 1 in einem zweiten Betätigungszustand.

Das erfindungsgemäße Betätigungselement ist in vorteilhafter Weise in elektronischen Haushaltsgeräten zum Einstellen und Auswählen verschiedener Betriebsparameter (z.B. Waschprogramm, Spülprogramm, Schleuderdrehzahl, Temperatur, Kochzeit, Kochstufe, etc.) einsetzbar.

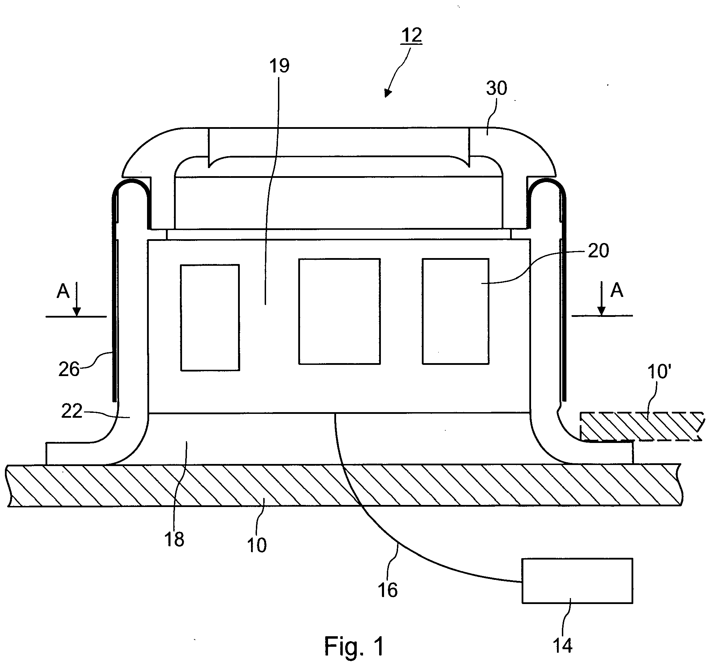

Das Betätigungselement 12 ist zum Beispiel an einer aus Kunststoff oder Metall gefertigten Bedienblende 10, 10' eines Haushaltsgerätes angebracht. In einer Variante ist das Betätigungselement 12 auf die dem Benutzer zugewandte Außenseite (oben in Fig. 1) der Bedienblende 10 aufgesetzt, wobei die elektrischen Anschlüsse durch eine entsprechende Durchbrechung in der Bedienblende 10 hindurch geführt sind oder eine drahtlose Verbindung vorgesehen ist. In einer anderen Variante ist das Betätigungselement 12 von hinten (unten in Fig. 1) durch eine Durchbrechung in der Bedienblende 10' hindurch geschoben, sodass es in Richtung zum Benutzer aus der Bedienblende 10' heraus ragt. In jedem Fall ist das Betätigungselement 12 fest an der Bedienblende 10, 10' montiert (z.B. durch Verkleben, Verrasten, Verpressen, Verschrauben, etc.), zu Reparaturzwecken aber vorzugsweise lösbar.

Wie in Fig. 1 angedeutet, ist das Betätigungselement 12 über wenigstens eine (leitungsgebundene oder drahtlose) Verbindungsleitung 16 mit einer Steuervorrichtung 14 verbunden. Diese Steuervorrichtung 14 kann - je nach Ausführungsform des Betätigungselements 12 - in diesem selbst integriert, direkt an diesem angebracht oder separat von diesem positioniert sein.

Aufbau und Funktionsweise eines bevorzugten Ausführungsbeispiels des erfindungsgemäßen Betätigungselements 12 werden nun Bezug nehmend auf Fig. 1 bis 3 näher erläutert.

Das in diesem Ausführungsbeispiel als Drehknopf ausgeführtes Betätigungselement 12 weist einen knopfförmigen Träger 18 aus einem elektrisch nicht-leitfähigen Kunststoffmaterial mit einem im Wesentlichen zylindrischen Detektionsabschnitt 19 mit einer im Wesentlichen kreisförmigen Grundfläche und einer von dieser im Wesentlichen geradlinig ausgehenden Mantelfläche auf. Entlang dieser Mantelfläche des Detektionsabschnitts 19 sind an dem Träger 18 mehrere, elektrisch leitfähige Messelektroden 20 angeordnet.

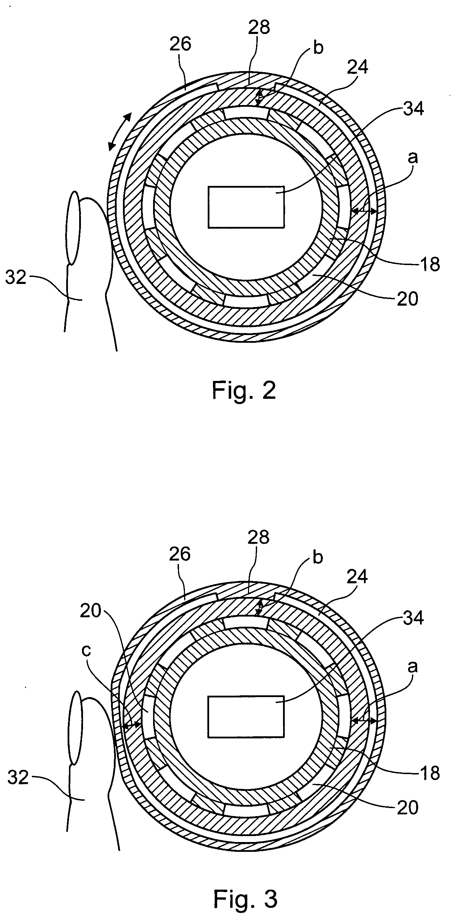

Wie in Fig. 2 angedeutet, sind die Messelektroden 20 jeweils in Ausnehmungen oder Taschen im Träger 18 aufgenommen und auf diese Weise durch Trennwände des Trägers zueinander beabstandet und voneinander elektrisch isoliert. In diesem Ausführungsbeispiel sind insgesamt acht Messelektroden 20 um den gesamten Umfang der Mantelfläche, d.h. entlang des gesamten Detektionsabschnitts 19 und in einer Reihe auf einem Kreis angeordnet. An diesem Ausführungsbeispiel haben die Messelektroden jeweils eine rechteckige Grundform und sind parallel zur Mantelfläche des zylindrischen Detektionsabschnitts gekrümmt.

Die Messelektroden 20 sind jeweils mit der Steuervorrichtung 14 verbunden, sodass die Kapazitätswerte bzw. die Kapazitätswertveränderungen an allen Messelektroden zeitlich synchron oder sequentiell erfasst und ausgewertet werden können.

Der Detektionsabschnitt 19 des Trägers 18 ist von einem ringförmigen, elektrisch nicht-leitfähigen Isolationselement 22 aus einem Kunststoffmaterial umgeben. Das Isolationselement 22 ist fest mit dem Träger 18 verbunden, zum Beispiel auf diesen aufgesteckt und im Fußbereich mit diesem verklebt.

Das Isolationselement 22 ist im Bereich des Detektionsabschnitts 19 des Trägers 18 von einem ebenfalls im Wesentlichen ringförmigen Bedienelement 26 vollumfänglich umgeben. Das Bedienelement 26 ist aus einem elektrisch leitfähigen Material wie zum Beispiel Metall, bevorzugt Edelstahl gefertigt. Wie insbesondere in Fig. 2 und 3 erkennbar, ist das Bedienelement 26 zudem über einen Luftspalt 24 radial von dem Isolationselement 22 beabstandet.

Wie in Fig. 1 beispielhaft veranschaulicht, ist das Bedienelement 26 zudem so geformt, dass es an dem Isolationselement 22 eingehängt werden kann. Das Bedienelement 26 ist dabei durch das Isolationselement 22 nur geführt, sodass es relativ zu diesem und damit auch zum Träger 18, insbesondere auch zur Anordnung der Messelektroden 20 am Träger 18 herum gedreht werden kann. Das Bedienelement 26 ist dabei im Wesentlichen koaxial zum Detektionsabschnitt 19 des Trägers 18 angeordnet.

Das Bedienelement 26 kann dabei je nach Ausführungsform des Betätigungselements endlos um den Träger 18 herum gedreht werden oder durch einen oder mehrere Anschläge in seinem Drehwinkel begrenzt sein.

Des Weiteren ist das Bedienelement 26 mit einem Sensorabschnitt 28 versehen. In diesem Ausführungsbeispiel ist dieser Sensorabschnitt 28 durch eine Materialverstärkung oder eine Prägung des Metallringes 26 ausgebildet, wie in Fig. 2 und 3 dargestellt.

Berührt ein Benutzer zum Beispiel mit seinem Finger 32 des Metallring 26, so bildet dieser zusammen mit den Messelektroden 20 jeweils eine Kapazität, wobei das Isolationselement 22 und der Luftspalt 24 ein Dielektrikum bilden. Die Kapazitätswerte können an den Messelektroden 20 abgegriffen und von der Steuervorrichtung 14 ausgewertet werden.

Wie in Fig. 2 dargestellt, ist das Bedienelement 26 von der Anordnung der Messelektroden 20 in radialer Richtung um einen ersten vordefinierten Abstand a beabstandet. Der Sensorabschnitt 28 des Bedienelements 26 ist hingegen von der Anordnung der Messelektroden 20 in radialer Richtung m einen zweiten vordefinierten Abstand b beabstandet, der von dem ersten vordefinierten Abstand verschieden ist (a ≠ b). Im vorliegenden Ausführungsbeispiel ist der zweite vordefinierte Abstand b kleiner als der erste vordefinierte Abstand a (b < a).

Wird das Bedienelement 26 nun von einem Benutzer mit einem oder mehreren Fingern 32 um den Träger 18 herum gedreht, so bewegt sich auch der Sensorabschnitt 28 am Bedienelement 26 relativ zu den Messelektroden 20. Hierdurch ändern sich die Kapazitätswerte der Kapazitäten an den Messelektroden 20, da sich der Abstand zwischen den Elektroden 20, 28 und die Dicke des Dielektrikums 22, 24 dazwischen verändern.

Durch ein synchrones oder sequentielles Abfragen der Messwerte an den Messelektroden 20 kann die Steuervorrichtung 14 deshalb eine Drehwinkel und/oder eine Drehrichtung des Bedienelements 26 um den Träger 18 ermitteln. Mit Hilfe einer solchen Drehbewegung kann ein Benutzer zum Beispiel ein Programm (z.B. Waschprogramm, wie Kochwäsche, Buntwäsche, Schonprogramm, etc.) und/oder einen gewünschten Parameter (z.B. Temperatur, Schleuderdrehzahl, Kochzeit, etc.) auswählen.

Zum Bestätigen einer auf diese Weise getroffenen Auswahl ist es möglich, einen zusätzlichen (mechanischen oder berührungsempfindlichen) Tastschalter vorzusehen. In einem bevorzugten Ausführungsbeispiel der Erfindung ist diese Funktionalität aber mit in das Betätigungselement 12 integriert.

Wie in Fig. 3 angedeutet, ist das ringförmige Bedienelement 26 in den Bereichen außerhalb des Sensorabschnitts 28 elastisch verformbar. In diesem Fall kann auch das Isolationselement 22 zwischen dem Bedienelement 26 und den Messelektroden 20 elastisch verformbar, insbesondere komprimierbar ausgebildet sein.

Durch einen Druck auf das Bedienelement 26 zum Beispiel mit einem Finger 32 des Benutzers wird der Abstand zwischen dem Bedienelement 26 und der Anordnung der Messelektroden 20 bis zu einem dritten vordefinierten Abstand c verändert. Dieser dritte vordefinierte Abstand c unterscheidet sich sowohl von dem ersten vordefinierten Abstand a als auch dem zweiten vordefinierten Abstand b (a ≠ b ≠ c). Je deutlicher sich diese vordefinierten Abstände a, b, c voneinander unterscheiden, umso größer ist die erzielbare Genauigkeit und Zuverlässigkeit bei der Erfassung einer Betätigung des Betätigungselements. Der dritte vordefinierte Abstand c kann wahlweise größer oder kleiner als der zweite vordefinierte Abstand b gewählt werden (c > b oder c < b), je nachdem ob das Isolationselement 22 komprimierbar ausgebildet ist oder nicht.

Eine Abstandsänderung zwischen dem Bedienelement 26 und den Messelektroden 20 auf den dritten vordefinierten Abstand c bewirkt eine entsprechende Veränderung des Kapazitätswertes an der jeweiligen Messelektrode 20. Diese Kapazitätsänderung kann von der Steuervorrichtung 14 erfasst und als eine Druckbetätigung des Bedienelement 26 durch den Benutzer zum Beispiel zum Bestätigen seiner zuvor durch eine Drehbewegung des Bedienelements 26 getroffenen Auswahl gewertet werden.

Zum Vereinfachen der Bedienung sind die verformbaren Abschnitte bzw. Bereiche des Bedienelements 26 für den Benutzer gekennzeichnet, zum Beispiel optisch und/oder haptisch.

Ferner ist auf der dem Benutzer zugewandten Stirnseite des Betätigungselements 12 (oben in Fig. 1) auf den Träger 18 eine Abdeckung 30 gesetzt. Diese Abdeckung 30 ist beispielsweise ein Spritzgussteil aus einem Kunststoffmaterial. Außerdem ist die Abdeckung 30 fest mit dem Träger 18 verbunden (z.B. durch Verpressen Verrasten, Verkleben, etc.).

In einer bevorzugten Ausführungsform des Betätigungselements 12 ist die Abdeckung 30 zumindest teilweise transparent bzw. lichtdurchlässig ausgebildet. Innerhalb des Trägers 18 ist wenigstens ein Anzeigeelement 34 angeordnet, wie in Fig. 2 und 3 angedeutet. Mit dem Anzeigeelement 34 können dem Benutzer Informationen zum Beispiel über die aktuellen Parametereinstellungen und den Betriebszustand des Gerätes angezeigt werden.

Bei dem Anzeigeelement 34 handelt es sich zum Beispiel um ein Display. Dieses Display 34 wird vorzugsweise von der Steuervorrichtung 14 angesteuert. Neben diesem Display 34 können weitere Anzeigeelemente, zum Beispiel in Form von Leuchtdioden(gruppen) oder mit Leuchtdioden(gruppen) gekoppelten Lichtleitern vorgesehen sein.

### Bezugszeichenliste

- 10: Bedienblende
- 10': Bedienblende
- 12: Betätigungselement / Drehknopf
- 14: Steuervorrichtung
- 16: Verbindungsleitung
- 18: Träger
- 19: (zylindrischer) Detektionsabschnitt
- 20: Messelektroden
- 22: Isolationselement
- 24: Luftspalt
- 26: (ringförmiges) Bedienelement
- 28: Sensorabschnitt an 26
- 30: (stirnseitige) Abdeckung
- 32: Finger
- 34: Anzeigeelement

## Patentansprüche

1. Betätigungselement (12), insbesondere für ein elektronisches Haushaltsgerät, aufweisend:
einen elektrisch nicht-leitfähigen Träger (18), welcher wenigstens einen Detektionsabschnitt (19) definiert;
mehrere elektrisch leitfähige Messelektroden (20), welche zueinander beabstandet entlang des Detektionsabschnitts (19) des Trägers (18) angeordnet sind; und
ein Bedienelement (26), welches in einem ersten vordefinierten Abstand (a) zu den Messelektroden (20) angeordnet ist und relativ zu diesen bewegbar ist,
wobei das Bedienelement (26) wenigstens einen Sensorabschnitt (28) aufweist, welcher zumindest teilweise elektrisch leitfähig ausgestaltet ist und in einem zweiten vordefinierten Abstand (b), welcher von dem ersten vordefinierten Abstand (a) verschieden ist, zu den Messelektroden (20) angeordnet ist,
wobei das Bedienelement (26) aus einem elektrisch leitfähigen Material gebildet ist **dadurch gekennzeichnet, dass**
der Detektionsabschnitt (19) des Trägers (18) im Wesentlichen als eine Mantelfläche eines Zylinders ausgestaltet ist; und
das Bedienelement (26) im Wesentlichen ringförmig ausgestaltet und im Wesentlichen koaxial zum Detektionsabschnitt (19) des Trägers (18) angeordnet ist.

2. Betätigungselement nach Anspruch 1,
**dadurch gekennzeichnet, dass**
zwischen den Messelektroden (20) und dem Bedienelement (26) wenigstens ein elektrisch nicht-leitfähiges Isolationselement (22) und/oder ein Luftspalt (24) vorgesehen sind.

3. Betätigungselement nach Anspruch 1 oder 2,
**dadurch gekennzeichnet, dass**
das Bedienelement (26) zumindest teilweise elastisch verformbar ausgestaltet ist.

4. Betätigungselement nach Anspruch 3,
**dadurch gekennzeichnet, dass**
das Bedienelement (26) bis zu einem dritten vordefinierten Abstand (c) zu den Messelektroden (20) verformbar ausgestaltet ist, welcher von dem ersten vordefinierten Abstand (a) und von dem zweiten vordefinierten Abstand (b) verschieden ist.

5. Betätigungselement nach Anspruch 3 oder 4,
**dadurch gekennzeichnet, dass**
das Bedienelement (26) nur in Bereichen verformbar ausgestaltet ist, in denen kein Sensorabschnitt (28) am Bedienelement vorgesehen ist.

6. Betätigungselement nach einem der Ansprüche 3 bis 5,
**dadurch gekennzeichnet, dass**
zwischen den Messelektroden (20) und dem Bedienelement (26) wenigstens ein komprimierbares, elektrisch nicht-leitfähiges Isolationselement (22) und/oder ein Luftspalt (24) vorgesehen sind.

7. Betätigungselement nach einem der vorhergehenden Ansprüche,
**dadurch gekennzeichnet, dass**
die Messelektroden (20) mit einer Steuervorrichtung (14) verbunden sind, welche in/an dem Betätigungselement (12) angeordnet ist.

8. Betätigungselement nach einem der vorhergehenden Ansprüche,
**dadurch gekennzeichnet, dass**
das Betätigungselement (12) eine dem Benutzer zugewandte Abdeckung (30), welche zumindest teilweise lichtdurchlässig ausgebildet ist und wenigstens ein Anzeigeelement (34) aufweist.

9. Elektronisches Haushaltsgerät mit einer Bedienblende (10, 10') und wenigstens einem Betätigungselement (12) nach einem der vorhergehenden Ansprüche.

## Claims

1. Actuating element (12), in particular for an electronic domestic appliance, having:
an electrically non-conductive carrier (18) which defines at least one detection portion (19);
a plurality of electrically conductive measuring electrodes (20) which are arranged spaced apart from one another along the detection portion (19) of the carrier (18); and
an operating element (26) which is arranged at a first predefined distance (a) from the measuring electrodes (20) and is movable relative thereto, wherein the operating element (26) has at least one sensor portion (28) which is at least partially electrically conductive and is arranged at a second predefined distance (b) from the measuring electrodes (20), which second predefined distance is different from the first predefined distance (a), wherein the operating element (26) is made of an electrically conductive material
**characterized in that**
the detection portion (19) of the carrier (18) is formed substantially as a lateral surface of a cylinder; and
the operating element (26) is substantially annular and is arranged substantially coaxially with the detection portion (19) of the carrier (18).

2. Actuating element according to Claim 1,
**characterized in that**
at least one electrically non-conductive insulation element (22) and/or an air gap (24) is/are provided between the measuring electrodes (20) and the operating element (26).

3. Actuating element according to Claim 1 or 2,
**characterized in that**
the operating element (26) is at least partially resiliently deformable.

4. Actuating element according to Claim 3,
**characterized in that**
the operating element (26) is deformable up to a third predefined distance (c) from the measuring electrodes (20), which third predefined distance is different from the first predefined distance (a) and from the second predefined distance (b).

5. Actuating element according to Claim 3 or 4,
**characterized in that**
the operating element (26) is deformable only in regions in which no sensor portion (28) is provided on the operating element.

6. Actuating element according to one of Claims 3 to 5,
**characterized in that**
at least one compressible, electrically non-conductive insulation element (22) and/or an air gap (24) is/are provided between the measuring electrodes (20) and the operating element (26).

7. Actuating element according to one of the preceding claims,
**characterized in that**
the measuring electrodes (20) are connected to a control device (14) which is arranged in/on the actuating element (12).

8. Actuating element according to one of the preceding claims,
**characterized in that**
the actuating element (12) has a cover (30) facing the user, which cover is at least partially permeable to light and has at least one indicating element (34).

9. Electronic domestic appliance having an operator control panel (10, 10') and at least one actuating element (12) according to one of the preceding claims.

## Revendications

1. Élément d'actionnement (12), notamment pour un appareil ménager électronique, comportant :
un support non électroconducteur (18) qui définit au moins une section de détection (19) ;
plusieurs électrodes de mesure (20) électroconductrices qui sont disposées espacées les unes des autres le long de la section de détection (19) du support (18) ; et
un élément de commande (26) qui est disposé à une première distance prédéfinie (a) des électrodes de mesure (20) et peut être déplacé par rapport à celles-ci,
dans lequel l'élément de commande (26) présente au moins une section de capteur (28) qui est conçue au moins en partie électroconductrice et est disposée à une deuxième distance prédéfinie (b), qui est différente de la première distance (a) prédéfinie, des électrodes de mesure (20),
dans lequel l'élément de commande (26) est formé d'un matériau électroconducteur, **caractérisé en ce que** la section de détection (19) du support (18) est sensiblement conçue comme une surface circonférentielle d'un cylindre ; et
l'élément de commande (26) est sensiblement conçu annulaire et est disposé sensiblement coaxialement à la section de détection (19) du support (18).

2. Élément d'actionnement selon la revendication 1,
**caractérisé en ce qu'**il est prévu au moins un élément d'isolation (22) non électroconducteur et/ou un entrefer (24) entre les électrodes de mesure (20) et l'élément de commande (26).

3. Élément d'actionnement selon la revendication 1 ou 2,
**caractérisé en ce que** l'élément de commande (26) est au moins en partie déformable élastiquement.

4. Élément d'actionnement selon la revendication 3,
**caractérisé en ce que** l'élément de commande (26) est conçu déformable jusqu'à une troisième distance prédéfinie (c) des électrodes de mesure (20), qui est différente de la première distance prédéfinie (a) et de la deuxième distance prédéfinie (b).

5. Élément d'actionnement selon la revendication 3 ou 4,
**caractérisé en ce que** l'élément de commande (26) est conçu déformable uniquement dans les zones dans lesquelles aucune section de capteur (28) n'est prévue sur l'élément de commande.

6. Élément d'actionnement selon l'une des revendications 3 à 5,
**caractérisé en ce qu'**il est prévu au moins un élément d'isolation (22) compressible non électroconducteur et/ou un entrefer (24) entre les électrodes de mesure (20) et l'élément de commande (26).

7. Élément d'actionnement selon l'une des revendications précédentes, **caractérisé en ce que** les électrodes de mesure (20) sont reliées à un dispositif de commande (14) qui est disposé dans/sur l'élément d'actionnement (12).

8. Élément d'actionnement selon l'une des revendications précédentes,
**caractérisé en ce que** l'élément d'actionnement (12) comporte un couvercle (30) tourné vers l'utilisateur, qui est au moins partiellement transparent, et au moins un élément d'affichage (34).

9. Appareil ménager électronique comprenant un panneau de commande (10, 10') et au moins un élément d'actionnement (12) selon l'une des revendications précédentes.
